# EUROPÄISCHE PATENTSCHRIFT

(11) **EP 1 097 478 B1**
(45) Veröffentlichungstag und Bekanntmachung des Hinweises auf die Patenterteilung: **07.05.2003**
(21) Anmeldenummer: 99947194.9
(22) Anmeldetag: 06.07.1999
(51) Int. Cl.: H01L 23/48, H01L 23/482, H01L 23/485, H01L 21/60, H01L 23/532, H01L 23/31

(54) **HALBLEITERBAUELEMENT IM CHIP-FORMAT UND VERFAHREN ZU SEINER HERSTELLUNG**
SEMICONDUCTOR COMPONENT IN A CHIP FORMAT AND METHOD FOR THE PRODUCTION THEREOF
ELEMENT SEMI-CONDUCTEUR EN FORMAT DE PUCE ET SON PROCEDE DE PRODUCTION

(30) Priorität: 14.07.1998 DE 19832706
(43) Veröffentlichungstag der Anmeldung: 09.05.2001
(60) Teilanmeldung: 03003230.4
(73) Patentinhaber: Infineon Technologies AG, 81669 München (DE)
(72) Erfinder: HACKE, Hans-Jürgen, D-81475 München (DE); GALUSCHKI, Klaus-Peter, D-12526 Berlin (DE)
(74) Vertreter: Schweiger, Martin, Dipl.-Ing.
(86) Internationale Anmeldenummer: DE9902118
(87) Internationale Veröffentlichungsnummer: WO00004584

(56) Entgegenhaltungen:
- EP-A- 0 734 059
- WO-A-96/22620
- US-A- 4 922 321
- US-A- 5 074 947
- US-A- 5 340 775
- US-A- 5 477 087
- US-A- 5 663 086
- US-A- 5 672 542
- PATENT ABSTRACTS OF JAPAN vol. 017, no. 375 (E-1397), 14. Juli 1993 (1993-07-14) -& JP 05 062981 A (OKI ELECTRIC IND CO LTD), 12. März 1993 (1993-03-12) -& DATABASE WPI Week 9315 Derwent Publications Ltd., London, GB; AN 1993-122913 XP002131509
- PATENT ABSTRACTS OF JAPAN vol. 018, no. 599 (E-1631), 15. November 1994 (1994-11-15) -& JP 06 232134 A (ROHM CO LTD), 19. August 1994 (1994-08-19) in der Anmeldung erwähnt
- BABA S ET AL: "MOLDED CHIP SCALE PACKAGE FOR HIGH PIN COUNT" PROCEEDINGS OF THE ELECTRONIC COMPONENTS AND TECHNOLOGY CONFERENCE,US,NEW YORK, IEEE, Bd. CONF. 46, 28. Mai 1996 (1996-05-28), Seiten 1251-1257, XP000684987 ISBN: 0-7803-3287-3
- "SOLDER PLATED RESIN BALL" IBM TECHNICAL DISCLOSURE BULLETIN,US,IBM CORP. NEW YORK, Bd. 38, Nr. 5, 1. Mai 1995 (1995-05-01), Seiten 463-464, XP000519647 ISSN: 0018-8689
- PATENT ABSTRACTS OF JAPAN vol. 010, no. 386 (E-467), 24. Dezember 1986 (1986-12-24) & JP 61 177746 A (HITACHI LTD), 9. August 1986 (1986-08-09)
- MORRIS J.R. ET AL.: 'Stencil Printing of Solder Paste for Fine-pitch Surface Mount Assembly' IEEE TRANSACTIONS ON COMPONENTS, HYBRIDS, AND MANUFACTURING TECHNOLOGY Bd. 14, Nr. 3, 01 September 1991, NEW YORK, US, Seiten 560 - 566
- P. VAN ZANT: "Microchip Fabrication", Mai 1998, WILEY, NEW YORK

## Beschreibung

Aus der veröffentlichten europäischen Patentanmeldung EP 0 734 059 A2 ist ein sogenanntes Chip-size-Halbleiterbauelement bekannt, also ein Halbleiterbauelement im Chip-Format, das sich dadurch auszeichnet, daß es in seinen flächigen Abmessungen im wesentlichen denen des Chips entspricht und nur in der Höhe größer als der Chip ist. Bei dem bekannten Halbleiterbauelement sind die äußeren Anschlüsse oberhalb der Oberfläche des eigentlichen Chip angebracht, indem der Chip auf einer Oberfläche neben einer Passivierungsschicht eine erste Isolierschicht und von diesen Isolierschichten freie elektrische Anschlußflächen aufweist; mit diesen elektrischen Anschlußflächen ist die innerhalb des Chips angeordnete Elektronik elektrisch verbunden. Auf der ersten Isolierschicht verlaufen Leiterbahnen, die von den elektrischen Anschlußflächen ausgehen und an Fußpunkten äußerer Anschlußelemente enden. Die äußeren Anschlußelemente sind bei dem bekannten Halbleiterbauelement von jeweils einer Lotkugel gebildet, die durch eine Öffnung in einer weiteren Isolierschicht bis zu der Leiterbahn reicht und dort ihren Fußpunkt hat. Die äußeren Anschlußelemente in Form der Lotkugeln sind dabei so angeordnet, wie es dem Raster von Lötpunkten auf einer gedruckten Leiterplatte entspricht. Das bekannte Halbleiterbauelement kann daher ohne weiteres durch Löten auf eine gedruckte Leiterplatte aufgebracht werden.

Die "Solder Plated Resin Ball", IBM technical disclosure bulletin, Vol. 38, No.5, 1. Mai 1995, Seiten 463-464 [XP 519647] zeigt ein aussen mit Lotmaterial beschichtetes Kunststoffkügelchen zum einsatz in der Flip-Chip-Technologie.

Die US-A-5, 074, 947 zeigt ein Verfahren zum Verbinden von Bond Pads eines Flip-Chips mit Bond Pads eines Substrats unter Verwendung von leitendem polymermaterial, hierzu wird ein elektrisch leitfähiges Polymerisierbares Material auf den Bond Pads des Flip-Chips abgelagert, das sich über eine Schutzschicht hinaus erstreckt.

Der Erfindung liegt die Aufgabe zugrunde, ein Halbleiterbauelement im Chip-Format vorzuschlagen, das eine vergleichsweise gute mechanische Entkopplung von einer gedruckten Leiterplatte ermöglicht, wenn das Halbleiterbauelement auf die Leiterplatte aufgelötet ist.

Diese Aufgabe wird erfindungsgemäß durch ein Halbleiterbauelement im Chip-Format mit einem Chip gelöst, der auf mindestens einer Oberfläche mindestens eine erste Isolierschicht und von dieser Isolierschicht freie elektrische Anschlußflächen aufweist; der Chip ist ferner versehen mit auf der ersten Isolierschicht verlaufenden Leiterbahnen, die jeweils von den elektrischen Anschlußflächen zu Fußbereichen äußerer Anschlußelemente führen, mit einer auf den Leiterbahnen und auf der mindestens einen ersten Isolierschicht befindlichen weiteren Isolierschicht, die oberhalb des jeweiligen Fußbereichs eine Durchgangsöffnung mit eingebrachten Leitkleber aufweist, und mit außen metallisierten Hunststoff-Kügelchen, die jeweils im Bereich des freien Endes der Durchgangsöffnungen auf den Leitkleber aufgesetzt sind.

Ein wesentlicher Vorteil des erfindungsgemäßen Halbleiterbauelementes ergibt sich durch den in die Durchgangsöffnungen der weiteren Isolierschicht eingebrachten Leitkleber, weil ein solcher Leitkleber auch nach seiner Aushärtung vergleichsweise gute elastische Eigenschaften aufweist, so daß beispielsweise durch eine Erwärmung eines aus einer gedruckten Leiterplatte und dem Halbleiterbauelement gebildeten Verbundes mit einhergehenden unterschiedlichen thermischen Beanspruchungen diese Beanspruchungen von den Verbindungsstellen zwischen dem Halbleiterbauelement und der Leiterplatte ferngehalten werden. Hinzukommt, daß der ausgehärtete Leitkleber ein verhältnismäßig gutes Alterungsverhalten bei mechanischer Wechsellast aufweist.

Bei dem erfindungsgemäßen Halbleiterbauelement ist die weitere Isolierschicht erheblich dicker als die mindestens eine erste Isolierschicht ausgeführt. Dies schafft die vorteilhafte Möglichkeit, relativ viel Leitkleber in die Durchgangsöffnung einzufüllen, wodurch sich nach Aushärtung relativ lange Zylinder aus dem Leitklebermaterial bilden, die zur guten mechanischen Entkopplung von einer durch Löten mit dem Halbleiterbauelement verbundenen Leiterplatte vorteilhaft beitragen.

Die außen metallisierten Kunststoffkügelchen zeichnen sich durch eine hohe Elastizität aus, so daß sie ganz wesentlich zur mechanischen Entkopplung des Halbleiterbauelementes von einer mit dem Halbleiterbauelement bestückten, gedruckten Leiterplatte beitragen. An sich ist es aus der US-Patentschrift 5,477,087 bekannt, zur Verbindung von Halbleiterbauelementen mit Leiterplatten Anschlußelemente zu verwenden, die einen Kunststoffkern mit Metallüberzug aufweisen, jedoch sind diese Anschlußelemente über eine Metallschicht mit der Anschlußfläche des Chips verbunden.

Der Erfindung liegt ferner die Aufgabe zugrunde, ein Verfahren zum Herstellen eines Halbleiterbauelementes im Chip-Format anzugeben, mit dem sich auf vergleichsweise einfache Weise Halbleiterbauelemente herstellen lassen, die gute mechanische Entkopplungseigenschaften aufweisen.

Eine Lösung dieser Aufgabe besteht in einem Verfahren, bei dem auf mindestens eine Oberfläche des Chip mindestens eine erste Isolierschicht unter Freilassung elektrischer Anschlußflächen aufgebracht werden, auf die mindestens eine erste Isolierschicht zu jeweils einem Fußbereich äußerer Anschlußelemente führende Leiterbahnen aufgebracht werden, auf die Leiterbahnen und auf die mindestens eine erste Isolierschicht eine weitere Isolierschicht mit Durchgangsöffnungen oberhalb des jeweiligen Fußbereichs vorgesehen werden, in die Durchgangsöffnungen Leitkleber eingebracht wird, außen metallisierten Kunststoffkügelchen jeweils im Bereich des freien Endes der Durchgangsöffnungen auf den Leitkleber aufgesetzt werden und der Leitkleber ausgehärtet wird.

Ein wesentlicher Vorteil des erfindungsgemäßen Verfahrens besteht darin, daß mit ihm Halbleiterbauelemente mit mechanischen Entkopplungseigenschaften auf vergleichsweise einfache Weise hergestellt werden können, weil das Einbringen eines Leitklebers in die Durchgangsöffnungen der weiteren Isolierschicht und auch das Aufsetzen außen metallisierter KunststoffKügelchen auf den Leitkleber verhältnismäßig einfach verfahrenstechnisch durchgeführt werden kann.

Das erfindungsgemäße Verfahren lässt sich besonders einfach dann durchführen, wenn der Leitkleber in die Durchgangsöffnungen eingerakelt wird, weil das Einrakeln ein vergleichsweise einfacher Prozeßschritt ist. Für sich allerdings ist das Einrakeln von Lotpaste bereits bekannt, wie aus der veröffentlichten japanischen Patentanmeldung 6-232134 hervorgeht, die in der Dokumentation "Flip-Chip-Technologie, Vol. VII-1995 Update Foreign Patents", des Verlages International Interconnetion Intelligence, Seite 256 behandelt ist.

Besonders vorteilhaft läßt sich das erfindungsgemäße Verfahren dann durchführen, wenn die Verfahrensschritte an einem Wafer durchgeführt werden und nach dem Aushärten des Leitklebers ein Zertrennen des Wafers unter Gewinnung der Halbleiterbauelemente erfolgt.

Dies führt zu einer wesentlichen Kostenreduzierung, weil die einzelnen Verfahrensschritte nicht individuell bei jedem Chip, sondern gewissermaßen im Chipverbund durchgeführt werden, der von einem Wafer dargestellt wird.

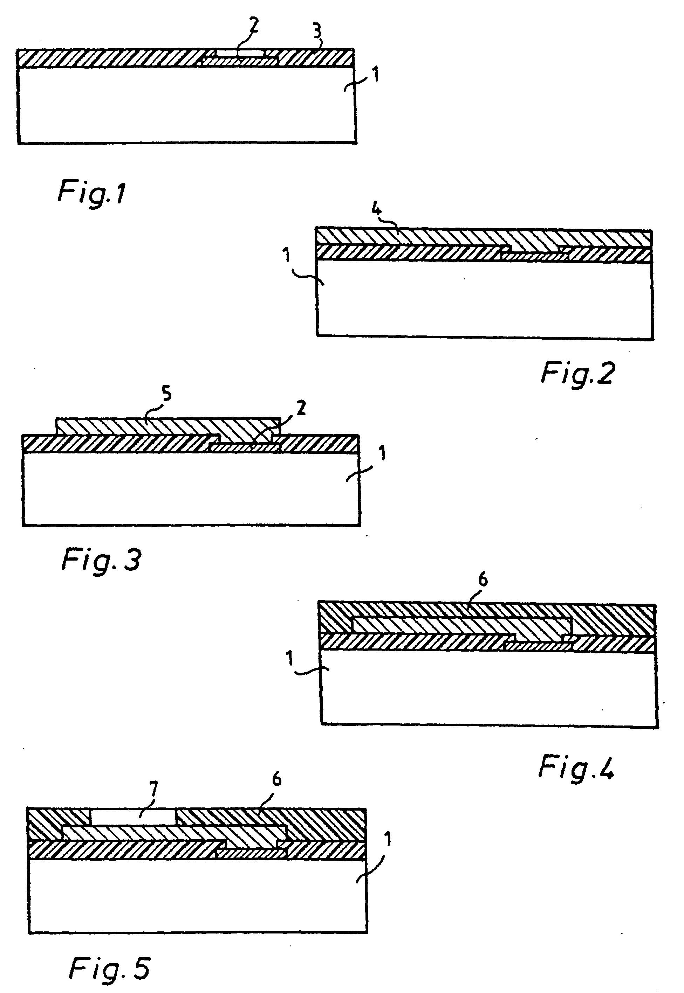

Zur Erläuterung der Erfindung sind in den Figuren 1 bis 9 die verschiedenen Verfahrensschritte bei der Durchführung eines Ausführungsbeispiels des erfindungsgemäßen Verfahrens dargestellt.

Die Figur 1 zeigt einen Ausschnitt aus einem Chip 1, der in üblicher Weise mit elektrischen Anschlußflächen 2, die häufig auch als Pads bezeichnet werden, versehen ist. Von den vielen Anschlußflächen 2 ist in der Figur 1 nur eine einzige der besseren Übersichtlichkeit halber dargestellt. Auf den Chip 1 ist eine Passivierungsschicht 3 in üblicher Weise so aufgebracht, daß sie die elektrischen Anschlußflächen 2 freiläßt.

Auf den soweit vorbereiteten Chip 1 wird in einem nächsten, in der Figur 2 dargestellten Verfahrensschritt eine Metallschicht 4 aufgebracht. Das Aufbringen kann durch eine Dünnfilmmetallisierung erfolgen, ggf. mit anschließender Verstärkung der Schicht 4 auf galvanischem Wege. Die Schicht 4 kann auch als ein Mehrschichtsystem aufgebaut sein. Wie die Figur 2 erkennen läßt, ist die Metallschicht 4 über den gesamten Chip 1 an seiner Oberseite aufgebracht.

Anschließend erfolgt - wie Figur 3 zeigt - eine Strukturierung der Metallschicht 4, wodurch Leiterbahnen 5 gebildet werden, die von den elektrischen Anschlußflächen 2 zu später noch näher beschriebenen Fußbereichen äußerer Anschlußelemente führen.

Die Figur 4 läßt erkennen, daß nach dem Strukturieren der Metallschicht 4 unter Bildung der Leiterbahnen 5 eine weitere Passivierungsschicht 6 auf den Chip 1 aufgebracht wird. Diese weitere Passivierungsschicht 6 deckt somit die Leiterbahnen 5 ab und verstärkt auch den Schutz der durch die erste Passivierungsschicht 3 gegeben ist.

Die Figur 5 läßt erkennen, daß danach die weitere Passivierungsschicht 6 unter Bildung einer Öffnung 7 geöffnet wird, was fototechnisch oder durch Laseranwendung geschehen kann.

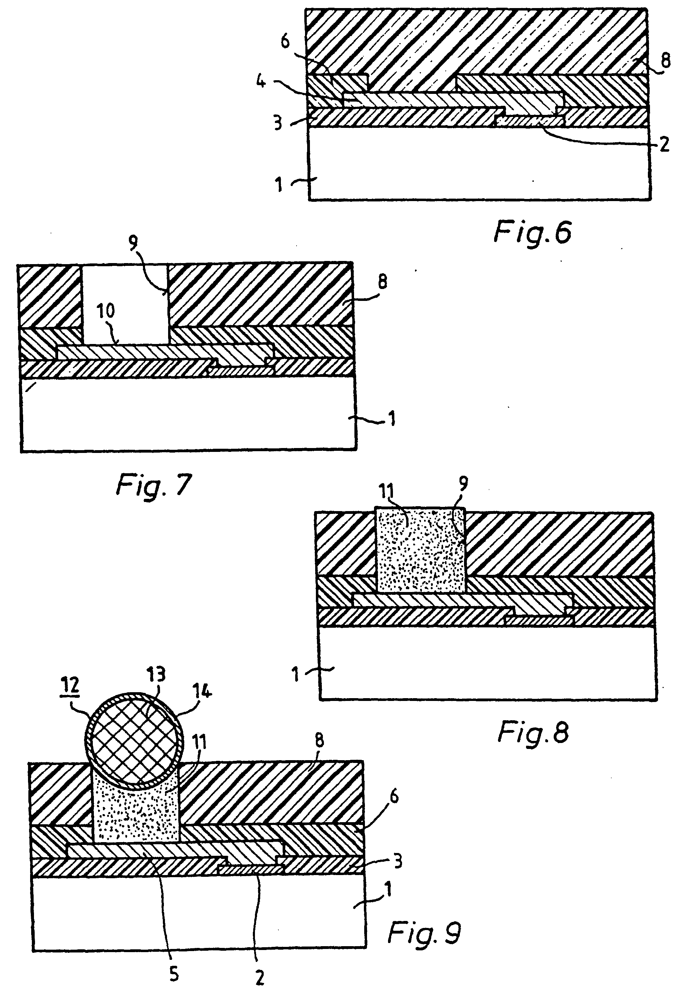

Vorzugsweise durch Siebdrucken, Schleudern oder Auflaminieren wird eine weitere Isolierschicht 8 auf den Chip 1 bzw. die weitere Passivierungsschicht 6 aufgebracht. Diese weitere Isolierschicht 8 ist erheblich dicker als die Passivierungsschicht 3; zusammen mit der weiteren Passivierungsschicht 6 ist sie etwa mindestens sechsmal so stark wie die Passivierungsschicht 3. Dies zeigt deutlich die Figur 6.

Die Figur 7 läßt erkennen, daß nach dem durch die Figur 6 dargestellten Verfahrensschritt die weitere Isolierschicht 8 unter Bildung eines Durchgangsloches 9 geöffnet wird, so daß sie einen freien Zugang zu einem Fußbereich 10 eines noch nicht gebildeten äußeren Anschlußelementes zuläßt. Das Öffnen der weiteren Isolierschicht 8 kann wiederum fototechnisch oder durch einen Laser erfolgen. Es ist aber auch möglich, die Öffnung 9 durch Anwendung eines Siebdruckes oder gelochten Filmes von vornherein vorzusehen, so daß dann ein Öffnen nicht erforderlich ist.

Anzumerken ist, daß das Aufbringen der weiteren Passivierungsschicht 6 und der weiteren Isolierschicht 8 auch gemeinsam erfolgen kann, so daß dann in einem einzigen Verfahrensschritt die Durchgangsöffnung 9 durch Freilegung der einzigen weiteren isolierenden Schicht oberhalb des Fußbereiches 10 erfolgen kann.

Nachdem der Chip 1 soweit vorbereitet ist, wie es die Figur 7 zeigt, wird die Durchgangsöffnung 9 mit leitfähigem Material gefüllt, bei dem es sich um einen Leitkleber handelt. Vorzugsweise wird das leitfähige Material eingerakelt. Als Schablone kann dabei die weitere Isolierschicht 8 dienen.

Schließlich wird - wie Figur 9 zeigt - auf das in der Durchgangsöffnung 9 befindliche leitfähige Material 11 ein außen metallisiertes Kunstsloffkügelchen 12 aufgesetzt, und es wird anschließend ein Aushärten des Leithlebers durchgeführt. Das außen metallisierte Kunststoffkügelchen 12 hat einen inneren Körper 13 aus Kunststoff, der außen mit einer Metallschicht 14 überzogen ist.

## Patentansprüche

1. Halbleiterbauelement im Chip-Format mit einem Chip (1) mit
- mindestens einer ersten Isolierschicht (3) und von dieser Isolierschicht (3) freien elektrischen Anschlußflächen (2) auf mindestens einer Oberfläche aufweist, mit
- auf der ersten Isolierschicht (3) verlaufenden Leiterbahnen (5), die
- jeweils von den elektrischen Anschlußflächen (2) zu Fußbereichen (10) äußerer Anschlußelemente (11, 12) führen, mit
- einer auf den Leiterbahnen (5) und auf der mindestens einen ersten Isolierschicht (3) befindlichen weiteren Isolierschicht (8),
- die erheblich dicker als die erste Isolierschicht (3) ist: zusammen mit einer gegebenenfalls vorgesehenen weiteren Passivierungs-schicht ( 6 ) etwa mindestens 6 mal so dick wie die erste Passivierungsschicht (3) und die oberhalb des jeweiligen Fußbereichs (10) eine Durchgangsöffnung (9) mit einem Zylinder aus eingebrachtem, ausgehärteten, elastischen Leitkleber (11) aufweist, und mit
- außen metallisierten Kunststoffkügelchen (12), die jeweils im Bereich des freien Endes der Durchgangsöffnungen ( 9 ) auf dem Zylinder aus dem Leitkleber (11) aufgesetzt sind.

2. Verfahren zum Herstellen eines Halbleiterbauelementes im Chip-Format mit einem Chip (1), bei dem
- auf mindestens einer Oberfläche des Chips (1) mindestens eine erste Isolierschicht (3) unter Freilassung elektrischer Anschlußflächen (2) aufgebracht wird,
- auf die mindestens eine erste Isolierschicht (3) zu jeweils einem Fußbereich (10) äußerer Anschlußelemente (11, 12) führende Leiterbahnen (5) aufgebracht werden,
- auf die Leiterbahnen (5) und auf die mindestens eine erste Isolierschicht (3) eine weitere Isolierschicht (8) vorgesehen wird, die erheblich dicker als die erste Isolierschicht (3) ist, nämlich zusammen mit einer ggfs. vorgesehenen weiteren Passivierungsschicht (6) etwa mindestens 6 mal so dick wie die erste Passivierungsschicht (3), wobei die weitere Isolierschicht (8) mit Durchgangsöffnungen (9) oberhalb des jeweiligen Fußbereichs (10) vorgesehen wird,
- in die Durchgangsöffnungen ( 9 ) Leitkleber (11) eingebracht wird,
- außen metallisierten Kunststoffkügelchen (12) jeweils im Bereich des freien Endes der Durchgangsöffnungen (9) auf den Leitkleber (11) aufgesetzt werden und der Leitkleber (11) ausgehärtet wird.

3. Verfahren nach Anspruch 2,
**dadurch gekennzeichnet, daß**
der Leitkleber (11) in die Durchgangsöffnungen (9) eingerakelt wird.

4. Verfahren nach einem der Ansprüche 2 oder 3,
**dadurch gekennzeichnet, daß**
die Verfahrensschritte an einem Wafer durchgeführt werden und nach dem Aushärten des Leitklebers ein Zertrennen des Wafers unter Gewinnung der Halbleiterbauelemente erfolgt.

## Claims

1. Semiconductor device in chip format having a chip (1) having
- at least one first insulating layer (3) and electrical connection pads (2) free of said insulating layer (3) on at least one surface, having
- interconnects (5) running on the first insulating layer (3), which interconnects
- in each case lead from the electrical connection pads (2) to base regions (10) of external connection elements (11, 12), having
- a further insulating layer (8) situated on the interconnects (5) and on the at least one first insulating layer (3), which further insulating layer
- is considerably thicker than the first insulating layer (3) : together with an optionally provided further passivation layer
(6) about at least 6 times as thick as the first passivation layer (3), and has, above the respective base region (10), a via opening (9) with a cylinder made of introduced, cured, elastic conductive adhesive (11), and having
- small plastic balls (12) which are metallized on the outside and are in each case placed on the cylinder made of the conductive adhesive (11) in the region of the free end of the via openings (9).

2. Method for producing a semiconductor device in chip format having a chip (1), in which
- at least one first insulating layer (3) is applied to at least one surface of the chip (1), with electrical connection pads (2) being left free,
- interconnects (5) leading to a respective base region (10) of external connection elements (11, 12) are applied to the at least one first insulating layer (3),
- on the interconnects (5) and on the at least one first insulating layer (3), provision is made of a further insulating layer (8), which is considerably thicker than the first insulating layer (3), namely together with an optionally provided further passivation layer (6) about at least 6 times as thick as the first passivation layer (3), the further insulating layer (8) being provided with via openings (9) above the respective base region (10),
- conductive adhesive (11) is introduced into the via openings (9),
- small plastic balls (12) which are metallized on the outside are in each case placed onto the conductive adhesive (11) in the region of the free end of the via openings (9), and
- the conductive adhesive (11) is cured.

3. Method according to Claim 2,
**characterized in that**
- the conductive adhesive (11) is introduced into the via openings (9) using a doctor blade.

4. Method according to either of Claims 2 or 3,
**characterized in that**
- the method steps are carried out on a wafer, and
- after the curing of the conductive adhesive, the wafer is divided to obtain the semiconductor devices.

## Revendications

1. Composant semi-conducteur en format de puce avec une puce (1) avec
- au moins une première couche isolante (3) et présentant sur une surface au moins, des surfaces de connexion (2) dépourvues de cette couche isolante (3), avec
- sur la première couche isolante (3), des pistes conductrices (5) qui mènent de chacune des surfaces de connexion électriques (2) aux zones des empreintes (10) des éléments de connexion externes (11, 12), avec
- sur les pistes conductrices (5) et sur une première couche isolante (3) au moins se trouve une couche isolante supplémentaire (8),
- qui est sensiblement plus épaisse que la première couche isolante (3) : ensemble avec une couche de passivation additionnelle (6) prévue le cas échéant, environ au moins 6 fois plus épaisse que la première couche de passivation (3) et qui présente au-dessus de la zone de l'empreinte (10) correspondante, une ouverture de passage (9) avec un cylindre de colle conductrice (11) élastique introduite et durcie, et avec
- de petites billes de matière plastique extérieurement métallisées (12) qui sont placées sur le cylindre de colle conductrice (11) dans la zone de l'extrémité libre des ouvertures de passage (9).

2. Procédé pour réaliser un composant semi-conducteur en format de puce avec une puce (1) dans lequel
- sur une surface au moins de la puce (1) est déposée au moins une première couche isolante (3) laissant libres des surfaces de connexion (2),
- sur la première couche isolante (3) au moins sont déposées des pistes conductrices (5) qui mènent chacune à une zone d'empreinte (10) d'éléments de connexion externes (11, 12),
- sur les pistes conductrices (5) et sur la première couche isolante (3) au moins est prévue une couche isolante supplémentaire (8) qui est sensiblement plus épaisse que la première couche isolante (3), en l'occurrence ensemble avec une couche de passivation additionnelle (6) prévue le cas échéant, environ au moins 6 fois plus épaisse que la première couche de passivation (3), la couche isolante supplémentaire (8) comportant des ouvertures de passage (9) au-dessus de la zone de l'empreinte (10) correspondante,
- de la colle conductrice (11) est introduite dans les ouvertures de passage (9),
- de petites billes de matière plastique extérieurement métallisées (12) sont chacune placées sur la colle conductrice (11) dans la zone de l'extrémité libre des ouvertures de passage (9) et la colle conductrice (11) est durcie.

3. Procédé selon la revendication 2, **caractérisé en ce que** la colle conductrice (11) est introduite dans les ouvertures de passage (9) avec une raclette.

4. Procédé selon une des revendications 2 ou 3, **caractérisé en ce que** les étapes du procédé sont exécutées sur un wafer et que le découpage du wafer pour obtenir les composants semi-conducteurs a lieu après durcissement de la colle conductrice.
